# EUROPEAN PATENT APPLICATION

(11) **EP 4 733 786 A1**
(43) Date of publication of application: **29.04.2026**
(21) Application number: 25816095.1
(22) Date of filing: 26.05.2025
(51) Int. Cl.: G01R 31/389, G01R 31/382, G01R 31/392, G01R 31/396, G01R 19/10, G01R 19/165

(54) **APPARATUS AND METHOD FOR DIAGNOSING BATTERY**

(30) Priority: 30.05.2024 KR 20240070935
(71) Applicant: LG Energy Solution, Ltd., Seoul 07335 (KR)
(72) Inventor: YU, Hye-In, Daejeon 34122 (KR); CHOI, Dong-In, Daejeon 34122 (KR)
(74) Representative: Goddar, Heinz J.
(86) International application number: PCT/KR2025/007098
(87) International publication number: WO 2025/249854

(57) **Abstract**

An apparatus for diagnosing a battery according to an embodiment of the present disclosure comprises a profile obtaining unit configured to obtain a charging profile representing a voltage change of a battery in a charging process according to a charging protocol in which a corresponding relationship between a charging C-RATE and a maximum allowable SOC is preset; and a control unit configured to calculate a voltage change amount of the battery at a charging start point of the charging profile, calculate a target resistance of the battery based on the calculated voltage change amount, and diagnose a state of the battery by comparing the target resistance with a first resistance profile in which a target resistance of the battery calculated in a previous charging cycle is stored.

## Description

### TECHNICAL FIELD

This application is based on and claims priority from Korean Patent Application No. 10-2024-0070935, filed on May 30, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery based on resistance generated during a charging process.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, it is necessary to prevent the phenomenon of lithium deposition on the surface of the negative electrode (lithium plating). If lithium is deposited on the surface of the negative electrode, it causes side reactions with the electrolyte and changes in the kinetic balance of the battery, which causes battery deterioration.

In addition, lithium plating may cause swelling of the battery. When swelling occurs in the battery, the center of the battery swells more than the edges of the battery, which may cause an uneven pressure distribution in the battery. This may cause problems such as a decrease in battery performance and a sudden death phenomenon in which the electrical connection is momentarily disconnected.

### DISCLOSURE

### Technical Problem

The present disclosure is designed to solve the problems of the related art, and therefore the present disclosure is directed to providing an apparatus and method for diagnosing a battery, which diagnoses a state of a battery having a risk of sudden death based on the resistance of the battery calculated in a charging process.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a charging profile representing a voltage change of a battery in a charging process according to a charging protocol in which a corresponding relationship between a charging C-RATE and a maximum allowable SOC is preset; and a control unit configured to calculate a voltage change amount of the battery at a charging start point of the charging profile, calculate a target resistance of the battery based on the calculated voltage change amount, and diagnose a state of the battery by comparing the target resistance with a first resistance profile in which a target resistance of the battery calculated in a previous charging cycle is stored.

The control unit may be configured to change the charging protocol when the state of the battery is diagnosed as an abnormal state.

The control unit may be configured to obtain a SOC-resistance profile representing a corresponding relationship between a SOC (State of Charge) of the battery, which is charged while repeating a charging period and a resting period with each charging C-RATE included in the charging protocol, and a resistance of the resting period, and change a maximum allowable SOC corresponding to each charging C-RATE based on the obtained SOC-resistance profile.

The control unit may be configured to set the maximum allowable SOC for the charging C-RATE corresponding to the SOC-resistance profile to an upper limit SOC, when a resistance corresponding to the upper limit SOC of a target SOC section is largest among a plurality of resistances corresponding to the target SOC section of the SOC-resistance profile.

The control unit may be configured to set the maximum allowable SOC for the charging C-RATE corresponding to the SOC-resistance profile based on at least one maximum point, when a resistance greater than the resistance corresponding to an upper limit SOC of a target SOC section exists among a plurality of resistances corresponding to the target SOC section of the SOC-resistance profile and the at least one maximum point exists in the target SOC section of the SOC-resistance profile.

The control unit may be configured to set the maximum allowable SOC for the charging C-RATE corresponding to the SOC-resistance profile based on at least one inflection point, when a resistance greater than the resistance corresponding to an upper limit SOC of a target SOC section exists among a plurality of resistances corresponding to the target SOC section of the SOC-resistance profile, there is no maximum point in the target SOC section, and the at least one inflection point exists in the target SOC section.

The control unit may be configured to determine a first resistance section based on the first resistance profile and diagnose the state of the battery by comparing the first resistance section with the target resistance.

The control unit may be configured to determine a first resistance line for a plurality of resistances included in the first resistance profile, and determine the first resistance section by adding a preset resistance threshold value to the determined first resistance line.

The control unit may be configured to diagnose the state of the battery as a normal state when the target resistance belongs to the first resistance section.

The control unit may be configured to diagnose the state of the battery as an abnormal state when the target resistance does not belong to the first resistance section.

The control unit may be configured to calculate a sub-voltage change amount between a voltage of the battery immediately after the charging starts and a voltage at time when the charging has been in progress for a preset time in the charging profile, calculate a sub-resistance of the battery based on the calculated sub-voltage change amount, and diagnose the state of the battery based on the target resistance and the sub-resistance.

The control unit may be configured to determine a second resistance section based on a second resistance profile in which a sub-resistance of the battery calculated from the previous charging cycle is stored, and diagnose the state of the battery based on the result of comparing the first resistance section with the target resistance and the result of comparing the second resistance section with the sub-resistance.

The control unit may be configured to determine a second resistance line for a plurality of resistances included in the second resistance profile, and determine the second resistance section by adding a preset resistance threshold value to the determined second resistance line.

The control unit may be configured to diagnose the state of the battery as a normal state when the target resistance belongs to the first resistance section or the sub-resistance belongs to the second resistance section.

The control unit may be configured to diagnose the state of the battery as an abnormal state when the target resistance does not belong to the first resistance section and the sub-resistance does not belong to the second resistance section.

The control unit may be configured to calculate the voltage change amount by calculating a difference between an initial voltage of the battery just before the charging starts and a voltage of the battery immediately after the charging starts.

The control unit may be configured to calculate an initial resistance based on the voltage change amount and a charging current of the charging process, compare an initial SOC of the battery just before the charging begins with a preset target SOC, and calculate the target resistance based on the initial resistance according to the comparison result.

The control unit may be configured to determine the initial resistance as the target resistance, when the initial SOC is equal to the target SOC.

The control unit may be configured to calculate the target resistance from the initial resistance based on a resistance table preset to represent a resistance ratio for each SOC, when the initial SOC is different from the target SOC.

The control unit may be configured to calculate a total resistance for the battery by dividing the initial resistance by a resistance ratio corresponding to the initial SOC in the resistance table, and calculate the target resistance for the battery by multiplying the total resistance by a resistance ratio corresponding to the target SOC in the resistance table.

A battery pack according to another aspect of the present disclosure may comprise the apparatus for diagnosing a battery according to one aspect of the present disclosure.

A method for diagnosing a battery according to still another aspect of the present disclosure may comprise a profile obtaining step of obtaining a charging profile representing a voltage change of a battery in a charging process according to a charging protocol in which a corresponding relationship between a charging C-RATE and a maximum allowable SOC is preset; a voltage change amount calculating step of calculating a voltage change amount of the battery at a charging start point of the charging profile; a target resistance calculating step of calculating a target resistance of the battery based on the calculated voltage change amount; and a diagnosing step of diagnose a state of the battery by comparing the target resistance with a first resistance profile in which a target resistance of the battery calculated in a previous charging cycle is stored.

The method for diagnosing a battery according to still another aspect of the present disclosure may further comprise a charging protocol changing step of changing the charging protocol when the state of the battery is diagnosed as an abnormal state in the diagnosing step.

### Advantageous Effects

According to one aspect of the present disclosure, the apparatus for diagnosing a battery may non-destructively diagnose the state of a battery based on the resistance behavior of the battery. In particular, the apparatus for diagnosing a battery may predict in advance whether a battery is likely to experience sudden death based on the resistance of the battery.

In addition, according to one aspect of the present disclosure, if the state of the battery is diagnosed as an abnormal state, the state of the battery may be prevented from deteriorating due to charging by changing the charging protocol.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a drawing schematically illustrating a charging profile according to an embodiment of the present disclosure.
FIG. 3 is an enlarged view illustrating a charging profile of FIG. 2.
FIG. 4 is a drawing that schematically illustrates a first resistance profile according to an embodiment of the present disclosure.
FIG. 5 is an enlarged view illustrating a first resistance profile of FIG. 4.
FIG. 6 is a drawing that schematically illustrates a capacity retention rate of a battery according to an embodiment of the present disclosure.
FIG. 7 is a drawing that schematically illustrates a resistance table according to an embodiment of the present disclosure.
FIG. 8 is a drawing that schematically illustrates a second resistance profile according to an embodiment of the present disclosure.
FIG. 9 is an enlarged view illustrating a second resistance profile of FIG. 8.
FIG. 10 is a drawing schematically illustrating a battery profile according to an embodiment of the present disclosure.
FIG. 11 is an enlarged view schematically illustrating a portion of the battery profile of FIG. 10.
FIG. 12 to FIG. 14 are drawings schematically illustrating a SOC-resistance profile according to an embodiment of the present disclosure.
FIG. 15 is a drawing comparing the first resistance profiles of a first battery and a second battery.
FIG. 16 is a drawing comparing the second resistance profiles of a first battery and a second battery.
FIG. 17 is a drawing comparing the capacity retention rates by cycle of a first battery and a second battery.
FIG. 18 is a drawing comparing the resistance increase rates by cycle of a first battery and a second battery.
FIG. 19 is a drawing schematically illustrating a battery pack according to another embodiment of the present disclosure.
FIG. 20 is a drawing schematically illustrating a vehicle according to still another embodiment of the present disclosure.
FIGS. 21 and 22 are diagrams schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

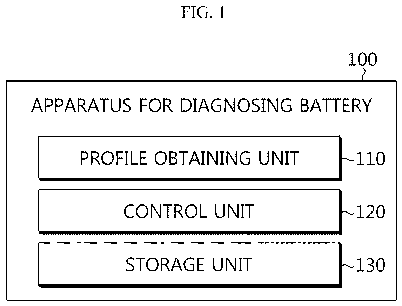

FIG. 1 is a diagram schematically illustrating an apparatus for diagnosing a battery according to an embodiment of the present disclosure.

Referring to FIG. 1, the apparatus for diagnosing a battery may include a profile obtaining unit and a control unit.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a charging profile CP representing a voltage change of a battery in a charging process according to a charging protocol in which a corresponding relationship between a charging C-RATE and a maximum allowable SOC is preset.

Specifically, the charging profile CP may be a profile representing a change in voltage according to time or capacity of the battery from a charging start point to a charging end point in a charging process. For example, the charging profile CP may be a profile representing a corresponding relationship between charging time and voltage. As another example, the charging profile CP may be a profile representing a corresponding relationship between SOC (state of charge) and voltage. As yet another example, the charging profile CP may be a profile representing a corresponding relationship between capacity and voltage.

Here, since the charging time, the capacity according to the charging time, and the SOC according to the charging time are mutually replaceable factors for time, there is no special limitation on the charging profile CP. However, below, for the convenience of explanation, the charging profile CP is described as a profile that represents the corresponding relationship between SOC and voltage.

For example, the profile obtaining unit 110 may directly receive the charging profile CP of the battery from the outside. That is, the profile obtaining unit 110 may obtain the charging profile CP by being connected to the outside via wire and/or wirelessly and receiving the charging profile CP.

As another example, the profile obtaining unit 110 may receive battery information about the voltage and SOC of the battery. Then, the profile obtaining unit 110 may generate a charging profile CP based on the received battery information. That is, the profile obtaining unit 110 may obtain the charging profile CP by directly generating the charging profile CP based on the battery information.

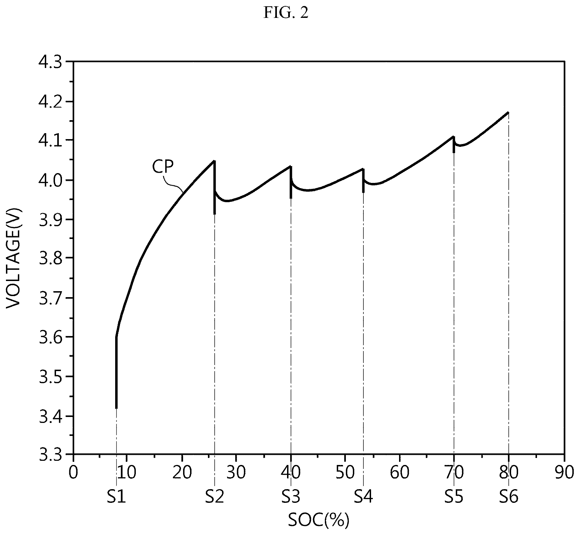

FIG. 2 is a drawing schematically illustrating a charging profile CP according to an embodiment of the present disclosure. In the embodiment of FIG. 2, the charging profile CP may be expressed as an X-Y graph with the X-axis set to SOC and the Y-axis set to voltage.

Specifically, the embodiment of FIG. 2 is a charging profile CP of a battery that is rapidly charged. For example, charging of the battery starts at SOC S1 (%), and rapid charging of the battery ends at SOC S6 (%). Then, the battery is rapidly charged while the charging C-RATE decreases at SOCs S2 (%), S3 (%), S4 (%), and S5 (%). That is, the charging C-RATE of the SOC section of S1 (%) to S2 (%) is greater than the charging C-RATE of the SOC section of S2 (%) to S3 (%). The C-RATE of the SOC section of S2 (%) to S3 (%) is greater than the C-RATE of the SOC section of S3 (%) to S4 (%). The C-RATE of the SOC section of S3 (%) to S4 (%) is greater than the C-RATE of the SOC section of S4 (%) to S5 (%). The C-RATE of the SOC section of S4 (%) to S5 (%) is greater than the C-RATE of the SOC section of S5 (%) to S6 (%). That is, the maximum allowable SOC that can be charged may be preset for each C-RATE.

The profile obtaining unit 110 may be connected to communicate with the control unit 120. For example, the profile obtaining unit 110 may be connected to the control unit 120 by wire and/or wirelessly. The profile obtaining unit may transmit the obtained charging profile CP to the control unit 120.

The control unit 120 may be configured to calculate a voltage change amount of the battery at a charging start point of the charging profile CP.

Specifically, the battery may be in a no-load state just before charging begins. Therefore, the initial voltage of the battery just before charging begins is OCV (open circuit voltage).

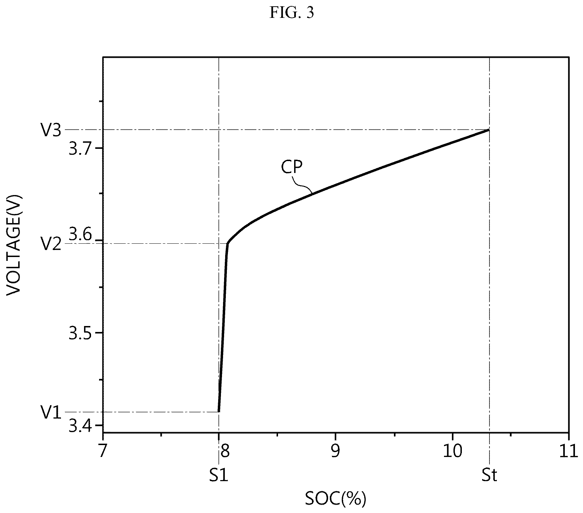

FIG. 3 is an enlarged view illustrating a charging profile of FIG. 2. For example, the SOC of the battery just before charging begins is S1 (%) and the voltage is V1 (V).

And, when charging starts, the voltage of the battery increases rapidly compared to the initial voltage due to the internal resistance of the battery. For example, assume that the terminal voltage of the battery is V, the initial voltage is OCV, the charging current is I, and the internal resistance of the battery is R. Here, the terminal voltage of the battery may be expressed according to the formula "V = OCV + IR". That is, immediately after charging starts, the voltage of the battery may increase by "IR".

The control unit 120 may be configured to calculate a voltage change amount by calculating the difference between the initial voltage of the battery just before charging begins and the voltage of the battery immediately after charging begins.

Specifically, the control unit 120 may calculate the voltage change amount by calculating the difference between the OCV of the battery just before charging starts and the terminal voltage of the battery immediately after charging starts.

For example, in the embodiment of FIG. 3, the control unit 120 may calculate the voltage change amount by calculating the formula "V2 - V1".

The control unit 120 may be configured to calculate the target resistance of the battery based on the calculated voltage change amount.

The control unit 120 may be configured to calculate the target resistance based on the voltage change amount and the charging current of the charging process.

Specifically, the control unit 120 may calculate the target resistance based on the voltage change amount and the charging current using Ohm's law. For example, assume that the voltage change amount is ΔV and the charging current is I. The control unit 120 may calculate the target resistance by calculating the formula "ΔV÷I".

For example, in the embodiments of FIGS. 2 and 3, it is assumed that the charging current for the SOC section of S1 (%) to S2 (%) is I. The control unit 120 may calculate the target resistance as the value obtained by dividing the voltage change amount (V2 - V1) by the charging current (I).

The control unit 120 may be configured to diagnose the state of the battery by comparing the target resistance with the first resistance profile P1 in which the target resistance of the battery calculated in the previous charging cycle is stored.

Specifically, the first resistance profile P1 is a profile in which the target resistance of the battery calculated for each previous charging cycle is stored. For example, assuming that the current cycle is the nth cycle, the target resistance calculated for the first to n-lth cycles may be stored in the first resistance profile P1. Then, when the battery state diagnosis for the nth cycle is completed, the target resistance calculated for the nth cycle may be stored in the first resistance profile P1.

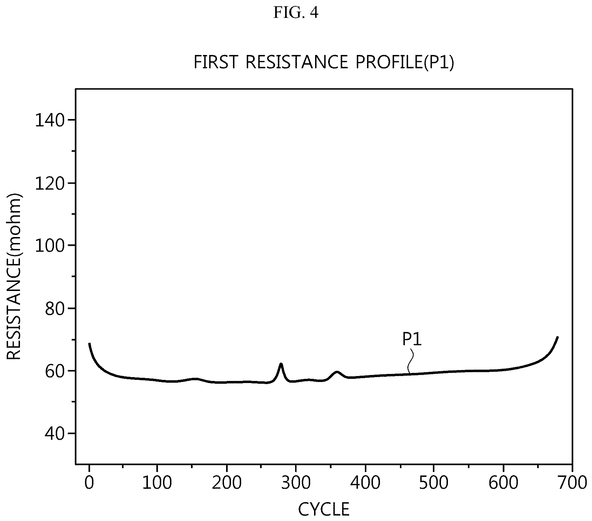

FIG. 4 is a drawing that schematically illustrates a first resistance profile P1 according to an embodiment of the present disclosure. In the embodiment of FIG. 4, the first resistance profile P1 may be expressed as an X-Y graph in which the X-axis is set to cycle and the Y-axis is set to resistance.

The control unit 120 may be configured to determine the first resistance section R1 based on the first resistance profile P1.

First, the control unit 120 may be configured to determine a first resistance line L1 for a plurality of resistances included in the first resistance profile P1.

For example, the control unit 120 may determine a first resistance line L1 for a first resistance profile P1 through regression analysis. Here, the first resistance line L1 may be linear or nonlinear.

As another example, the control unit 120 may determine the first resistance line L1 by considering the regression analysis result of the preset first reference resistance line and the first resistance profile P1 together. Here, the first reference resistance line is a resistance line derived from the first resistance profile P1 of the pre-designed reference battery. That is, the reference battery is a battery pre-designed as a normal state, and the first reference resistance line is a resistance line that may be applied to the battery in the normal state. Therefore, the control unit 120 may determine the first resistance line L1 corresponding to the first resistance profile P1 by grafting the first reference resistance line onto the regression analysis result of the first resistance profile P1.

Preferably, the control unit 120 may determine the first resistance line L1 for the first resistance profile P1 through regression analysis.

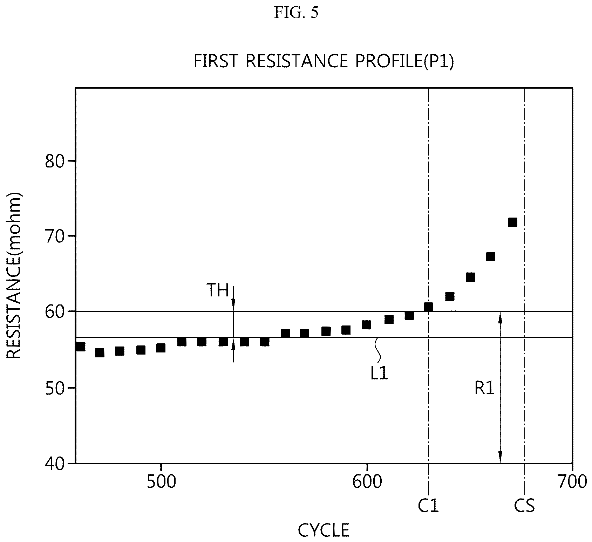

FIG. 5 is an enlarged view illustrating a first resistance profile P1 of FIG. 4. In the embodiment of FIG. 5, the control unit 120 may determine a first resistance line L1 of the first resistance profile P1.

The control unit 120 may be configured to determine the first resistance section R1 by adding a preset resistance threshold value to the determined first resistance line L1.

Specifically, the control unit 120 may adjust the first resistance line L1 by adding a preset resistance threshold value to the cycle-by-cycle resistance value according to the first resistance line L1. In addition, the control unit 120 may determine a resistance section equal to or smaller than the adjusted first resistance line L1 as the first resistance section R1.

For example, in the embodiment of FIG. 5, the control unit 120 may move the first resistance line L1 parallel to the Y-axis by adding a resistance threshold value TH to the cycle-by-cycle resistance value of the first resistance line L1. In addition, the control unit 120 may determine the resistance section equal to or smaller than the first resistance line L1 as the first resistance section R1.

In addition, the control unit 120 may be configured to diagnose the state of the battery by comparing the first resistance section R1 with the target resistance.

Specifically, the control unit 120 may diagnose the state of the battery depending on whether the target resistance belongs to the first resistance section R1.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

For example, the control unit 120 may be configured to diagnose the state of the battery as a normal state if the target resistance belongs to the first resistance section R1.

As another example, the control unit 120 may be configured to diagnose the state of the battery as an abnormal state if the target resistance does not belong to the first resistance section R1.

Here, the normal state means a state in which sudden death is unlikely to occur. And, the abnormal state means a state in which sudden death is highly predicted to occur. In other words, a battery diagnosed as in an abnormal state may be a battery in which sudden death is very likely to occur.

In general, when rapid charging is performed frequently, lithium plating phenomenon, in which lithium metal is deposited on the negative electrode surface, may occur more frequently than when normal charging is performed. In addition, since internal short circuit, fire, explosion, or sudden death that may appear due to lithium plating may occur suddenly, it is important to identify the warning symptoms in advance.

In particular, before sudden death occurs, the liquid diffusion resistance of lithium ions may increase significantly as byproducts accumulate at the interface between the negative electrode and the separator, clogging the pores of the separator and depleting the electrolyte. Since an increase in the liquid diffusion resistance is indicated by an increase in the target resistance, the control unit 120 may determine the possibility of sudden death of the battery based on whether the target resistance belongs to the first resistance section R1.

For example, in the embodiment of FIG. 5, the target resistance of the battery from the C1 cycle does not belong to the first resistance section R1. Therefore, the control unit 120 may diagnose the state of the battery as an abnormal state from the C1 cycle.

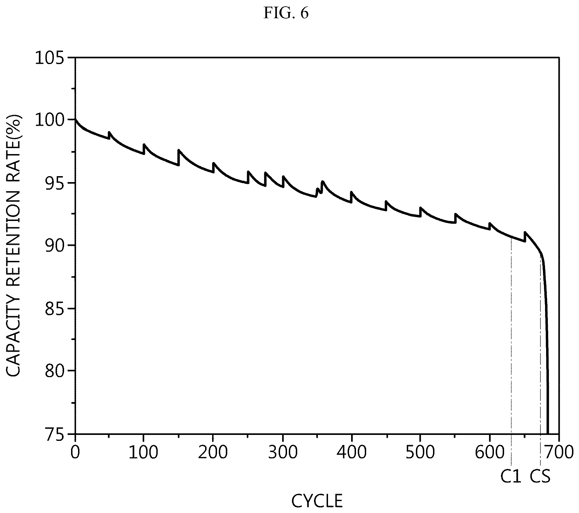

FIG. 6 is a drawing that schematically illustrates a capacity retention rate of a battery according to an embodiment of the present disclosure. Specifically, referring to FIG. 6, in the CS cycle, sudden death occurs in the battery and the capacity retention rate is dropped sharply to less than 75%. Since sudden death occurs suddenly in this way, the apparatus 100 for diagnosing a battery may predict and diagnose the possibility of sudden death in advance based on the behavior of target resistance.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store various information used for diagnosing the state of the battery, such as the charging profile CP, the first resistance profile P1, the first resistance line L1, the resistance threshold value TH, and the first resistance section R1.

Below, an embodiment is described in which the control unit 120 calculates the target resistance when the SOC of the charging start point of the battery is not constant for each cycle.

The control unit 120 may be configured to calculate the initial resistance based on the voltage change amount and the charging current of the charging process.

Additionally, the control unit 120 may be configured to compare the initial SOC of the battery just before charging begins with a preset target SOC.

Specifically, the target SOC may be preset to any one of the available SOC sections of the battery. For example, the target SOC may be preset to SOC 10%.

Depending on the situation in which the battery is used, the initial SOC of the battery just before charging begins may vary. For example, in the nth cycle, the battery may be charged from 8% SOC, and in the n+1th cycle, the battery may be charged from 15% SOC. Therefore, in order to more accurately calculate the target resistance, the control unit 120 may compare the initial SOC of the battery in the current cycle with the target SOC.

The control unit 120 may be configured to calculate the target resistance based on the initial resistance according to the comparison results.

Specifically, the control unit 120 may calculate the target resistance in a different way when the initial SOC is the same as the target SOC and when the initial SOC is different from the target SOC.

First, if the initial SOC is equal to the target SOC, the control unit 120 may be configured to determine the initial resistance as the target resistance.

Specifically, the control unit 120 may be configured to calculate the voltage change amount by calculating a difference between the initial voltage of the battery just before charging begins and the voltage of the battery immediately after charging begins. Then, the control unit 120 may calculate the initial resistance by dividing the calculated voltage change amount by the charging current. Finally, the control unit 120 may determine the calculated initial resistance as the target resistance of the battery.

Next, if the initial SOC is different from the target SOC, the control unit 120 may be configured to calculate the target resistance from the initial resistance based on a resistance table T preset to represent a resistance ratio for each SOC.

Specifically, the control unit 120 may convert the initial resistance corresponding to the initial SOC into the target resistance corresponding to the target SOC based on the preset resistance table T.

More specifically, the control unit 120 may be configured to determine the total resistance for the battery by dividing the initial resistance by a resistance ratio corresponding to the initial SOC in the resistance table T. In addition, the control unit 120 may be configured to calculate the target resistance for the battery by multiplying the calculated total resistance by a resistance ratio corresponding to the target SOC in the resistance table T.

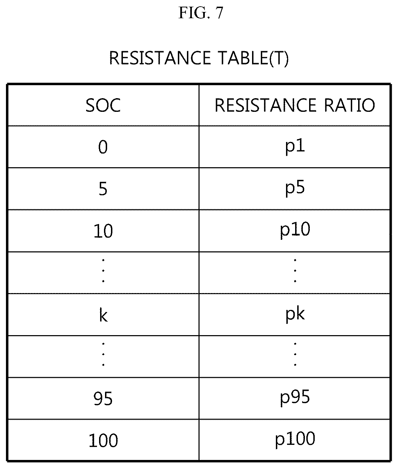

FIG. 7 is a drawing that schematically illustrates a resistance table T according to an embodiment of the present disclosure. In the embodiment of FIG. 7, the sum of the resistance ratios of p1 to p100 is 1 or 100%.

Meanwhile, in the embodiment of FIG. 7, the resistance table T is set at 5% SOC intervals, but the SOC interval in the resistance table T may be applied without limitation. Furthermore, the resistance ratio for the SOC (e.g., 3%) not included in the resistance table T may be interpolated and utilized based on the resistance ratios (pl and p5) of the adjacent SOCs (e.g., 0% and 5%).

In the embodiment of FIG. 7, it is assumed that the preset target SOC is 10%, the initial SOC of the battery is k%, and the initial resistance is R. The control unit 120 may calculate the total resistance of the battery by dividing the initial resistance R by the resistance ratio pk of the initial SOC. For example, the control unit 120 may calculate the total resistance of the battery by calculating the formula "R ÷ pk". In addition, the control unit 120 may determine the target resistance of the battery by multiplying the total resistance of the battery by the resistance ratio p10 of the target SOC. For example, the control unit 120 may calculate the target resistance of the battery by calculating the formula "R ÷ pk × p10".

That is, the control unit 120 may convert the initial resistance "R" corresponding to the initial SOC k (%) into the target resistance "R ÷ pk × p10" corresponding to the target SOC 10 (%). Then, the control unit 120 may diagnose the state of the battery based on the result of comparing the target resistance and the first resistance section R1.

The apparatus 100 for diagnosing a battery according to an embodiment of the present disclosure may determine the target resistance by considering a situation in which the initial SOC of the battery is not constant, and diagnose the state of the battery according to the determined target resistance. That is, the apparatus 100 for diagnosing a battery has an advantage in that it may diagnose the state of the battery even in a situation in which the initial SOC of the battery is not constant for each cycle by determining the target resistance using the resistance table T.

Below, an embodiment is described in which the control unit 120 supplementarily diagnoses the state of the battery by further considering sub-resistance.

The control unit 120 may be configured to calculate the sub-voltage change amount between the voltage of the battery immediately after charging starts in the charging profile CP and the voltage at the point when charging has been in progress for a preset time.

Specifically, the preset time may be determined within the time for charging at the same charging C-RATE from the charging start point. For example, the preset time may be 30 seconds.

For example, in the embodiment of FIG. 3, the initial voltage of the battery just before charging starts is V1, the voltage of the battery right after charging starts is V2, and the voltage of the battery at the point when charging has been in progress for a preset time is V3. The control unit 120 may calculate the sub-voltage change amount of the battery by calculating the formula "V3 - V2".

The control unit 120 may be configured to calculate the sub-resistance of the battery based on the calculated sub-voltage change amount.

For example, in the embodiments of FIGS. 2 and 3, it is assumed that the charging current for the SOC section of S1 (%) to S2 (%) is I. The control unit 120 may calculate the sub-resistance as the value obtained by dividing the sub-voltage change amount (V3 - V2) by the charging current (I).

The control unit 120 may be configured to diagnose the state of the battery based on the target resistance and the sub-resistance.

The control unit 120 may be configured to determine the second resistance section R2 based on a second resistance profile P2 in which the sub-resistance of the battery calculated from a previous charging cycle is stored.

Specifically, the second resistance profile P2 is a profile in which the sub-resistance of the battery calculated for each past charging cycle is stored. For example, assuming that the current cycle is the nth cycle, the sub-resistance calculated for the first to n-1th cycles may be stored in the second resistance profile P2. Then, when the battery state diagnosis for the nth cycle is completed, the sub-resistance calculated for the nth cycle may be stored in the second resistance profile P2.

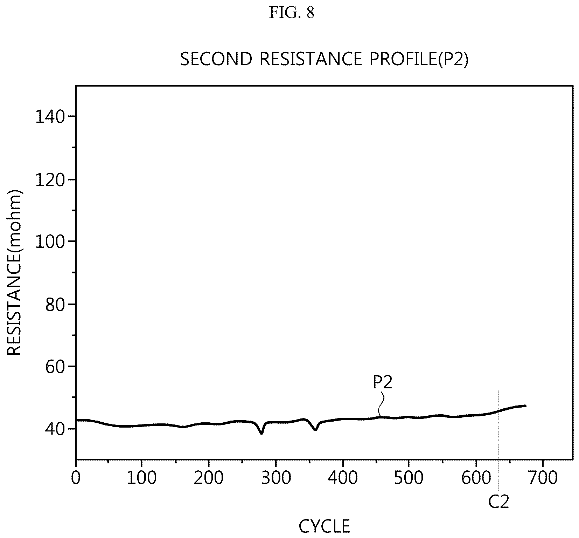

FIG. 8 is a drawing that schematically illustrates a second resistance profile P2 according to an embodiment of the present disclosure. In the embodiment of FIG. 8, the second resistance profile P2 may be expressed as an X-Y graph in which the X-axis is set to cycle and the Y-axis is set to resistance.

The control unit 120 may be configured to determine a second resistance line L2 for a plurality of resistances included in the second resistance profile P2.

For example, the control unit 120 may determine the second resistance line L2 for the second resistance profile P2 through regression analysis. Here, the second resistance line L2 may be linear or nonlinear.

As another example, the control unit 120 may determine the second resistance line L2 by considering the regression analysis result of the preset second reference resistance line and the second resistance profile P2 together. Here, the second reference resistance line is a resistance line derived from the second resistance profile P2 of a pre-designed reference battery. That is, the reference battery is a battery pre-designed in a normal state, and the second reference resistance line is a resistance line that may be applied to the battery in the normal state. Therefore, the control unit 120 may determine the second resistance line L2 corresponding to the second resistance profile P2 by grafting the second reference resistance line onto the regression analysis result of the second resistance profile P2.

Preferably, the control unit 120 may determine the second resistance line L2 for the second resistance profile P2 through regression analysis.

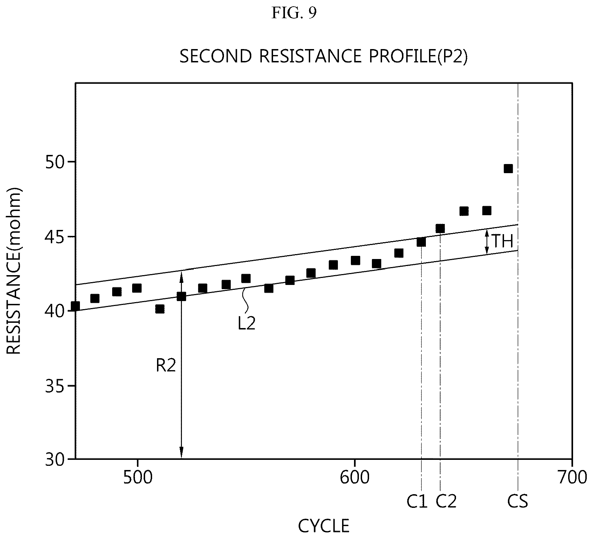

FIG. 9 is an enlarged view illustrating a second resistance profile P2 of FIG. 8. In the embodiment of FIG. 9, the control unit 120 may determine the second resistance line L2 of the second resistance profile P2.

The control unit 120 may be configured to determine the second resistance section R2 by adding a preset resistance threshold value to the determined second resistance line L2. Specifically, the control unit 120 may determine the second resistance section R2 by adding a resistance threshold value to the second resistance line L2 in the same manner as the first resistance section R1 is determined by adding a resistance threshold value to the first resistance line L1. Here, the resistance threshold value added to the first resistance line L1 and the resistance threshold value added to the second resistance line L2 may be the same as or different from each other.

For example, in the embodiment of FIG. 9, the control unit 120 may move the second resistance line L2 parallel to the Y-axis by adding the resistance threshold value TH to the cycle-by-cycle resistance value of the second resistance line L2. In addition, the control unit 120 may determine the resistance section equal to or smaller than the second resistance line L2 as the second resistance section R2.

In addition, the control unit 120 may be configured to diagnose the state of the battery based on the result of comparing the first resistance section R1 with the target resistance and the result of comparing the second resistance section R2 with the sub-resistance.

Specifically, the control unit 120 may diagnose the state of the battery based on whether the target resistance belongs to the first resistance section R1 and whether the sub-resistance belongs to the second resistance section R2.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

Next, if the resistance value of the sub-resistance is lower than or equal to the resistance value of the second resistance line L2, the control unit 120 may determine that the sub-resistance belongs to the second resistance section R2. Conversely, if the resistance value of the sub-resistance exceeds the resistance value of the second resistance line L2, the control unit 120 may determine that the sub-resistance does not belong to the second resistance section R2.

For example, the control unit 120 may be configured to diagnose the state of the battery as a normal state when the target resistance belongs to the first resistance section R1 or when the sub-resistance belongs to the second resistance section R2.

As another example, the control unit 120 may be configured to diagnose the state of the battery as an abnormal state if the target resistance does not belong to the first resistance section R1 and the sub-resistance does not belong to the second resistance section R2.

That is, the control unit 120 may diagnose the state of the battery as an abnormal state only when the target resistance does not belong to the first resistance section R1 and the sub-resistance does not belong to the second resistance section R2.

For example, in the embodiments of FIGS. 5, 6, and 9, the target resistance in the C1 cycle does not belong to the first resistance section R1, but the sub-resistance belongs to the second resistance section R2. That is, if only the target resistance is considered, the state of the battery in the C1 cycle is diagnosed as an abnormal state, but if both the target resistance and the sub-resistance are considered, the state of the battery in the C1 cycle is diagnosed as a normal state. Then, the target resistance in the C2 cycle does not belong to the first resistance section R1, and the sub-resistance does not belong to the second resistance section R2. That is, the state of the battery in the C2 cycle is diagnosed as an abnormal state. Then, sudden death occurs in the battery in the CS cycle after the C2 cycle.

When target resistance is used, the possibility of sudden death of the battery may be diagnosed earlier than when sub-resistance is used. For example, the first cycle (e.g., C1) in which the target resistance does not belong to the first resistance section R1 precedes the first cycle (e.g., C2) in which the sub-resistance does not belong to the second resistance section R2.

However, sudden death means a state in which the internal resistance of the battery increases rapidly and the battery cannot be charged or discharged, so the state of the battery should be diagnosed as an abnormal state from a conservative and strict point of view. If the state of the battery is diagnosed by considering only the target resistance, the state of the battery may be misdiagnosed, and since the state of the battery is diagnosed as an abnormal state before considering the sub-resistance, the period in which the battery can be used is shortened.

Therefore, the apparatus 100 for diagnosing a battery according to an embodiment of the present disclosure may diagnose the state of the battery more accurately by considering sub-resistance in addition to target resistance. Furthermore, the apparatus 100 for diagnosing a battery may increase the expected life of the battery by considering both target resistance and sub-resistance.

Below, an embodiment is described in which the charging protocol is changed depending on the diagnosed state of the battery.

Specifically, the control unit 120 may be configured to change the charging protocol when the state of the battery is diagnosed as an abnormal state. That is, when the state of the battery is diagnosed as a normal state, the preset charging protocol may not be changed. Conversely, when the state of the battery is diagnosed as an abnormal state, if the battery is charged using the charging protocol as it is, the state of the battery may become worse. Therefore, in such a case, it is necessary to change (modify, correct) the charging protocol.

The control unit 120 may be configured to repeat the charging period and the resting period with each charging C-RATE included in the charging protocol and obtain a SOC-resistance profile representing the corresponding relationship between the SOC (State of Charge) of the charged battery and the resistance of the resting period.

Here, the SOC-resistance profile is a profile that represents the corresponding relationship between the SOC of the battery and the resistance of the resting period when the battery is charged by repeating the charging period and the resting period with one charging C-RATE.

Preferably, the control unit 120 may obtain a SOC-resistance protocol for each charging C-RATE included in the charging protocol. For example, if the charging protocol includes information on n charging C-RATES, the control unit 120 may obtain n SOC-resistance protocols.

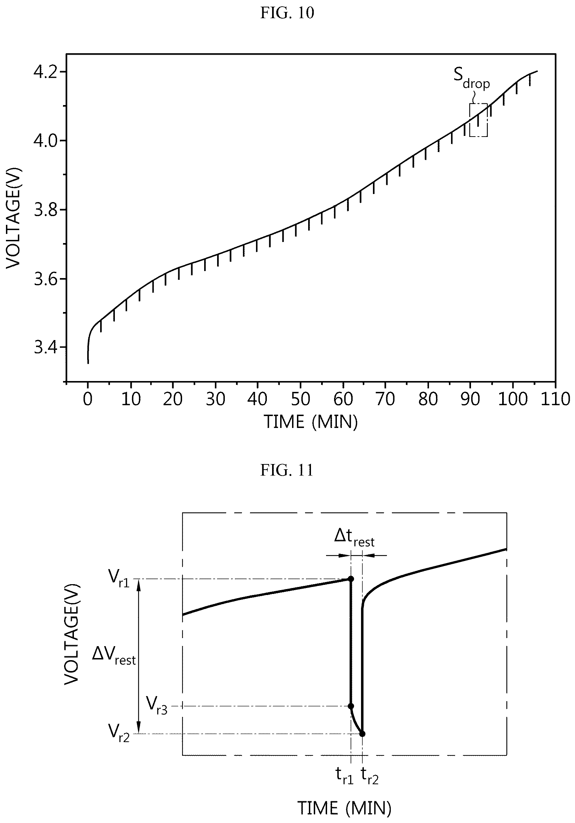

FIG. 10 is a drawing schematically illustrating a battery profile according to an embodiment of the present disclosure. For example, in the embodiment of FIG. 10, the battery is charged by repeating the charging period and the resting period at a predetermined charging C-RATE, and the corresponding relationship between the charging time and the voltage may be expressed as a battery profile. Since charging is temporarily suspended during the resting period, the voltage of the battery may drop.

FIG. 11 is an enlarged view schematically illustrating a portion of the battery profile of FIG. 10. The resting period may start at voltage Vᵣ₁ and end at voltage Vᵣ₂. The resting period may start at time tᵣ₁ and end at time tᵣ₂. That is, a voltage drop of ΔVᵣₑₛₜ may occur during time Δtᵣₑₛₜ. Considering Ohm's law, the resistance for the resting period may be calculated based on the charging current and the voltage drop amount (ΔVᵣₑₛₜ) corresponding to the charging C-RATE. Through this process, a SOC-resistance profile representing the corresponding relationship between SOC and resistance is generated, and the control unit 120 may obtain the generated SOC-resistance profile.

As another example, the control unit 120 may obtain a battery profile (e.g., FIG. 10) and calculate the SOC and resistance at each resting period. In addition, the control unit 120 may directly generate a SOC-resistance profile representing the corresponding relationship between the SOC and the resistance.

In the above embodiment, the voltage drop (ΔVᵣₑₛₜ) in the resting period is described as the difference between the resting period start voltage (Vᵣ₁) and the resting period end voltage (Vᵣ₂). Here, the difference between the resting period start voltage (Vᵣ₁) and the resting period end voltage (Vᵣ₂) is a value that includes both the Ohmic resistance and the charge transfer resistance of the battery. In some cases, the charge transfer resistance may represent the state of the battery more accurately than the Ohmic resistance. In addition, the charge transfer resistance may be expressed as the difference between the Vᵣ₃ voltage and the resting period end voltage (Vᵣ₂). Here, the Vᵣ₃ voltage may be the voltage at a point where the voltage change over time is greater than a preset reference value. Therefore, the voltage drop may be calculated based on the difference between the Vᵣ₃ voltage and the resting period end voltage (Vᵣ₂), and the resistance may be calculated based on the calculated voltage drop amount.

The control unit 120 may be configured to change the maximum allowable SOC corresponding to each charging C-RATE based on the obtained SOC-resistance profile.

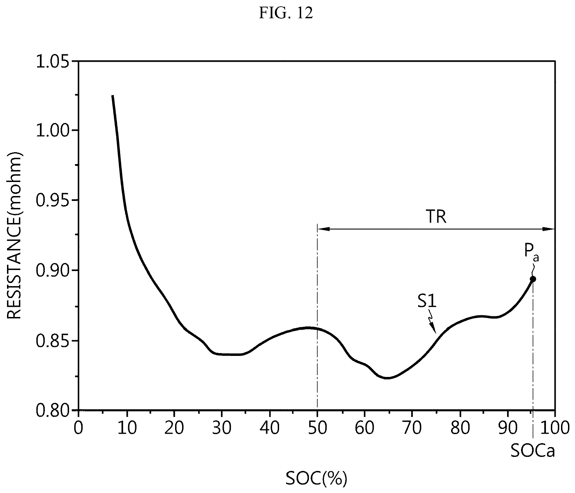

FIG. 12 to FIG. 14 are drawings schematically illustrating a SOC-resistance profile according to an embodiment of the present disclosure. Hereinafter, the target SOC section refers to a section with an SOC of 50% or more based on the BOL (Beginning of life) battery. In other words, as the battery deteriorates or the charging C-rate increases, the ratio included in the target SOC section in the SOC-resistance profile may decrease.

For example, the control unit 120 may be configured to set the maximum allowable SOC for the charging C-RATE corresponding to the SOC-resistance profile to the upper limit SOC, when the resistance corresponding to the upper limit SOC of the target SOC section is largest among the plurality of resistances corresponding to the target SOC section of the SOC-resistance profile.

Specifically, if the resistance corresponding to the upper limit SOC of the target SOC section is largest, the maximum allowable SOC for the charging C-RATE may be set to the upper limit SOC even if a maximum point and/or an inflection point exist in the target SOC section.

In the embodiment of FIG. 12, the first SOC-resistance profile S1 is a profile for a battery charged with n1 C-RATE. In the first SOC-resistance profile S1, Pₐ is an upper limit of the target SOC section TR. Among the plurality of resistances belonging to the target SOC section TR, the resistance corresponding to Pₐ is largest. Therefore, the maximum allowable SOC corresponding to n1 C-RATE may be set to the SOC (SOCₐ) corresponding to Pa.

As another example, the control unit 120 may be configured to set the maximum allowable SOC for the charging C-RATE corresponding to the SOC-resistance profile based on the at least one maximum point, if a resistance greater than the resistance corresponding to the upper limit SOC of the target SOC section exists among the plurality of resistances corresponding to the target SOC section and at least one maximum point exists in the target SOC section of the SOC-resistance profile.

Specifically, if the resistance corresponding to the upper limit SOC of the target SOC section is not greatest and a maximum point exists in the target SOC section, the maximum allowable SOC for the charging C-RATE may be set to the SOC of the maximum point even if an inflection point exists in the target SOC section.

Preferably, when the target SOC section includes a plurality of maximum points, the SOC of one of the plurality of maximum points may be set as the maximum allowable SOC. More preferably, the largest SOC among the SOCs corresponding to the plurality of maximum points may be set as the maximum allowable SOC.

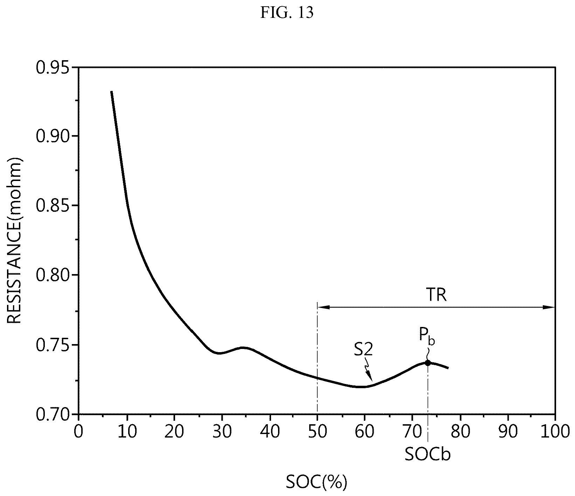

In the embodiment of FIG. 13, the second SOC-resistance profile S2 is a profile for a battery charged with n2 C-RATE. In the second SOC-resistance profile S2, P_{b} is a maximum point of the target SOC section TR. Among the plurality of resistances belonging to the target SOC section TR, the resistance corresponding to P_{b} is largest. That is, among the plurality of resistances belonging to the target SOC section TR, the resistance corresponding to the upper limit of the target SOC section TR is not largest. Therefore, the maximum allowable SOC corresponding to n2 C-RATE may be set to the SOC (SOC_{b}) corresponding to P_{b}.

As another example, the control unit 120 may be configured to set the maximum allowable SOC for the charging C-RATE corresponding to the SOC-resistance profile based on the at least one inflection point, if a resistance greater than the resistance corresponding to the upper limit SOC of the target SOC section exists among the plurality of resistances corresponding to the target SOC section, there is no maximum point in the target SOC section, and at least one inflection point exists in the target SOC section.

Specifically, even if an inflection point exists in the target SOC section, only if the resistance corresponding to the upper limit SOC is not largest among the plurality of resistances included in the target SOC section and the maximum point does not exist in the target SOC section, the SOC corresponding to the inflection point may be set to the upper limit SOC as the maximum allowable SOC for the charging C-RATE. This is because the maximum allowable SOC must be conservatively and strictly set to represent a SOC at which lithium plating does not occur even if the battery is charged at the charging C-RATE.

Preferably, when the target SOC section includes a plurality of inflection points, the SOC of one of the plurality of inflection points may be set as the maximum allowable SOC. More preferably, the largest SOC among the SOCs corresponding to the plurality of inflection points may be set as the maximum allowable SOC.

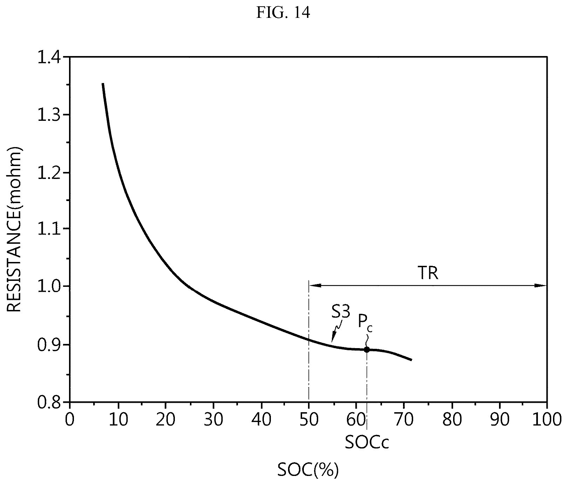

In the embodiment of FIG. 14, the third SOC-resistance profile S3 is a profile for a battery charged with n3 C-RATE. In the third SOC-resistance profile S3, P_{c} is an inflection point of the target SOC section TR. Among a plurality of resistances belonging to the target SOC section TR, the resistance corresponding to the upper limit SOC is not largest, and there is no maximum point in the target SOC section TR. Therefore, the maximum allowable SOC corresponding to n3 C-RATE may be set to the SOC (SOC_{c}) corresponding to P_{c}.

The apparatus 100 for diagnosing a battery according to the present disclosure may prevent the state of the battery from deteriorating due to subsequent charging by changing the charging protocol to correspond to the state of the diagnosed battery. In other words, the apparatus 100 for diagnosing a battery has the advantage of not only being able to diagnose the state of the battery, but also being able to set a customized charging protocol for the battery that may increase the expected lifespan of the battery.

Below, the performance of the first battery (Bₐ) whose charging protocol is not changed and the second battery (B_{b}) whose charging protocol is changed by the apparatus 100 for diagnosing a battery are compared and explained. Here, the charging protocol of the second battery (B_{b}) is changed based on 100 cycles.

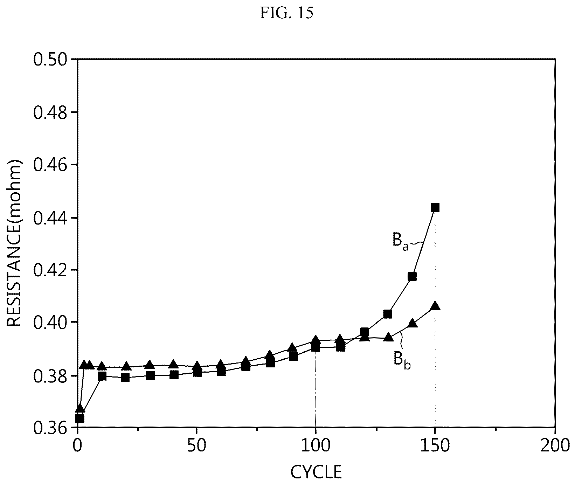

FIG. 15 is a drawing comparing the first resistance profile P1 of the first battery (Bₐ) and the second battery (B_{b}). The resistance of the first battery (Bₐ) with no change in charging protocol increases rapidly from about 120 cycles. On the other hand, the resistance of the second battery (B_{b}) with a change in charging protocol increases as the cycles progress, but the resistance does not increase rapidly like the first battery (Bₐ).

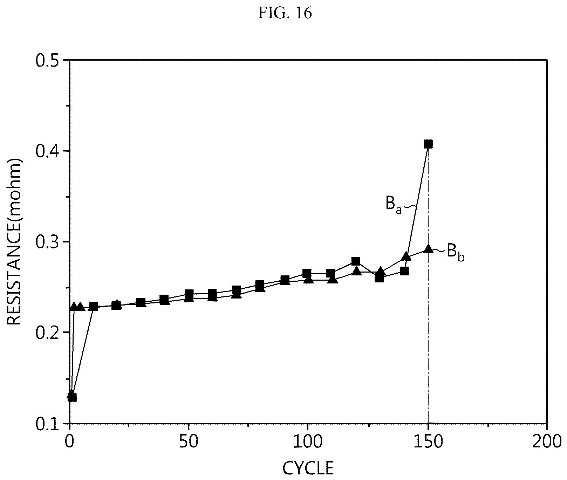

FIG. 16 is a drawing comparing the second resistance profile P2 of the first battery (Bₐ) and the second battery (B_{b}). The resistance of the first battery (Bₐ) with no change in charging protocol increases rapidly from about 140 cycles. On the other hand, the resistance of the second battery (B_{b}) with a change in charging protocol increases as the cycles progress, but the resistance does not increase rapidly like the first battery (Bₐ).

It may be confirmed that the resistance difference between the first battery (Bₐ) and the second battery (B_{b}) at 150 cycles is significantly different from the resistance difference between the first battery (Bₐ) and the second battery (B_{b}) at 100 cycles. That is, it may be confirmed that the state of the second battery (B_{b}) is prevented from deteriorating by changing the charging protocol.

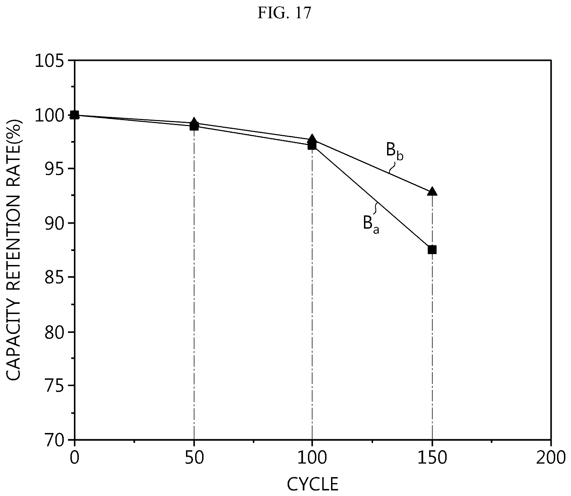

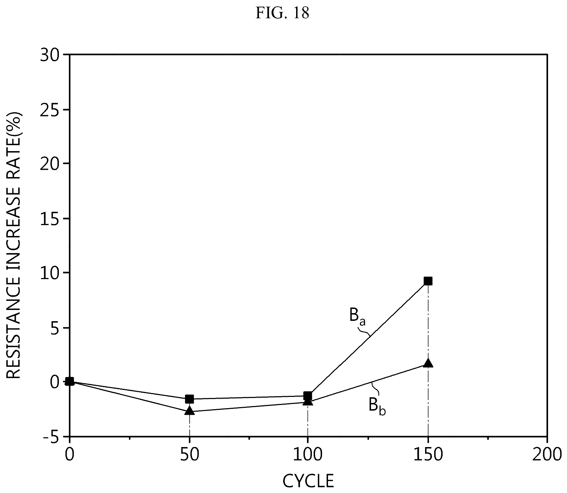

FIG. 17 is a drawing comparing the cycle-by-cycle capacity retention rate of the first battery (Bₐ) and the second battery (B_{b}). FIG. 18 is a drawing comparing the cycle-by-cycle resistance increase rate of the first battery (Bₐ) and the second battery (B_{b}).

Similar to the results of comparing the first battery (Bₐ) and the second battery (B_{b}) based on the first resistance profile P1 and the second resistance profile P2, the capacity retention rates and the resistance increase rates of the first battery (Bₐ) and the second battery (B_{b}) up to 100 cycles are almost similar. However, the capacity retention rates and the resistance increase rates of the first battery (Bₐ) and the second battery (B_{b}) at 150 cycles show a significant difference.

Depending on whether the charging protocol was changed, the capacity retention rates of the first battery (Bₐ) and the second battery (B_{b}) differed by about 5% after only 50 cycles (100 to 150 cycles), and the resistance increase rates differed by about 8%.

Through the embodiments for the first battery (Bₐ) and the second battery (B_{b}), it may be confirmed that the lifespan of the battery may be increased when the battery is charged according to the charging protocol changed by the apparatus 100 for diagnosing a battery.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack 10. That is, the battery pack according to the present disclosure may include the above-described apparatus 100 for diagnosing a battery and at least one battery cell. Additionally, the battery pack may further include electrical components (relays, fuses, etc.) and a case.

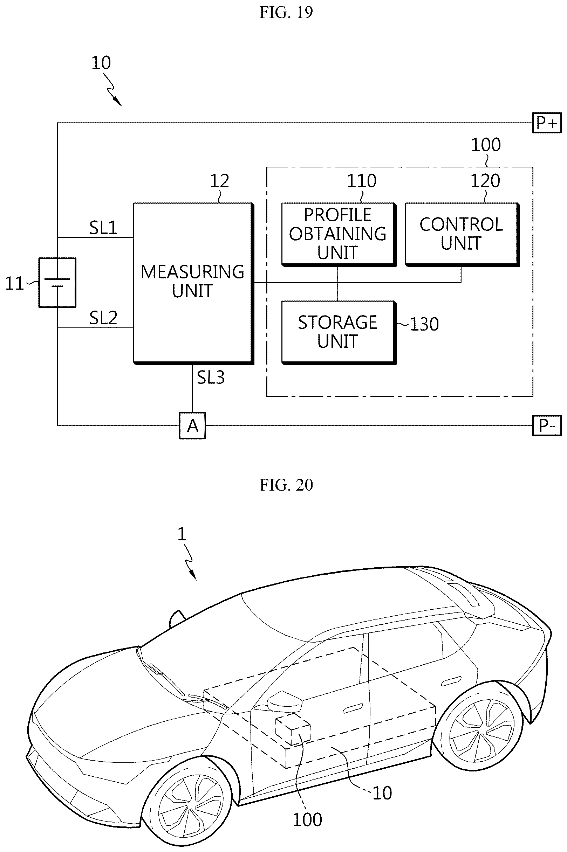

FIG. 19 is a diagram showing a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a charging profile CP based on the battery information.

As another example, the profile obtaining unit 110 may receive a charging profile CP from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 20 is a drawing schematically illustrating a vehicle 1 according to still another embodiment of the present disclosure.

Referring to FIG. 20, the battery pack 10 according to an embodiment of the present disclosure may be included in a vehicle 1, such as an electric vehicle (EV) or a hybrid vehicle (HV). In addition, the battery pack 10 may drive the vehicle 1 by supplying power to a motor through an inverter provided in the vehicle 1. Here, the battery pack 10 may include the apparatus 100 for diagnosing a battery. That is, the vehicle 1 may include the apparatus 100 for diagnosing a battery. In this case, the apparatus 100 for diagnosing a battery may be an onboard device included in the vehicle 1.

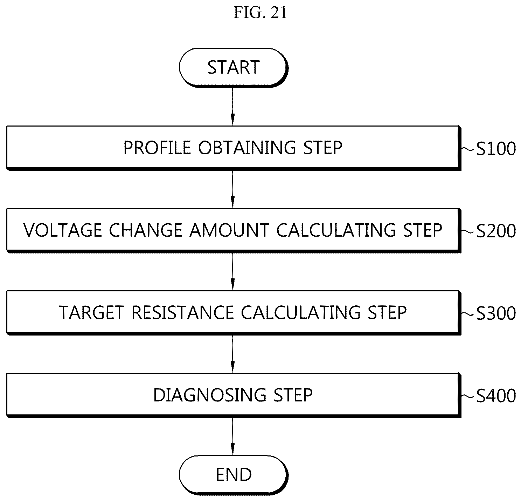

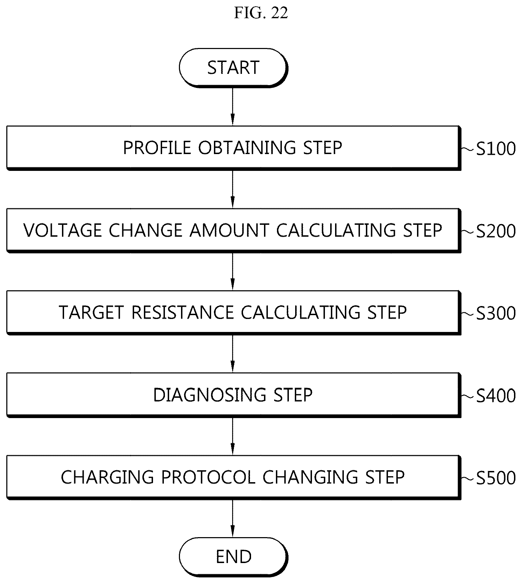

FIGS. 21 and 22 are diagrams schematically showing a method for diagnosing a battery according to still another embodiment of the present disclosure.

Referring to FIG. 21, the method for diagnosing a battery may include a profile obtaining step (S100), a voltage change amount calculating step (S200), a target resistance calculating step (S300), and a diagnosing step (S400).

Preferably, each step of the method for diagnosing a battery may be performed by the apparatus 100 for diagnosing a battery. Hereinafter, for convenience of explanation, contents overlapping with the previously described contents will be omitted or briefly described.

The profile obtaining step (S100) is a step of obtaining a charging profile CP representing a voltage change of a battery in a charging process, and may be performed by the profile obtaining unit 110.

For example, the profile obtaining unit 110 may directly receive the charging profile CP of the battery from the outside. That is, the profile obtaining unit 110 may obtain the charging profile CP by being connected to the outside via wire and/or wirelessly and receiving the charging profile CP.

As another example, the profile obtaining unit 110 may receive battery information about the voltage and SOC of the battery. Then, the profile obtaining unit 110 may generate a charging profile CP based on the received battery information. That is, the profile obtaining unit 110 may obtain the charging profile CP by directly generating the charging profile CP based on the battery information.

The voltage change amount calculating step (S200) is a step of calculating a voltage change amount of the battery at a charging start point of the charging profile CP, and may be performed by the control unit 120.

For example, the control unit 120 may be configured to calculate a voltage change amount by calculating the difference between the initial voltage of the battery just before charging begins and the voltage of the battery immediately after charging begins.

The target resistance calculating step (S300) is a step of calculating a target resistance of the battery based on the calculated voltage change amount, and may be performed by the control unit 120.

The control unit 120 may be configured to calculate the target resistance based on the voltage change amount and the charging current of the charging process.

For example, in the embodiments of FIGS. 2 and 3, it is assumed that the charging current for the SOC section of S1 (%) to S2 (%) is I. The control unit 120 may calculate the target resistance as a value obtained by dividing the voltage change amount (V2 - V1) by the charging current (I).

The diagnosing step (S400) is a step for diagnosing a state of the battery by comparing the target resistance with a first resistance profile P1 in which the target resistance of the battery calculated in the previous charging cycle is stored, and may be performed by the control unit 120.

The control unit 120 may be configured to determine the first resistance section R1 based on the first resistance profile P1.

In addition, the control unit 120 may be configured to diagnose the state of the battery by comparing the first resistance section R1 with the target resistance. For example, the control unit 120 may be configured to diagnose the state of the battery as a normal state if the target resistance belongs to the first resistance section R1. As another example, the control unit 120 may be configured to diagnose the state of the battery as an abnormal state if the target resistance does not belong to the first resistance section R1.

Referring to FIG. 22, the method for diagnosing a battery may further include a charging protocol changing step (S500).

The charging protocol changing step (S500) is a step for changing the charging protocol when the state of the battery is diagnosed as an abnormal state in the diagnosing step (S400), and may be performed by the control unit 120.

For example, the control unit 120 may be configured to set the maximum allowable SOC for the charging C-RATE corresponding to the SOC-resistance profile to the upper limit SOC, when a resistance corresponding to the upper limit SOC of the target SOC section is largest among the plurality of resistances corresponding to the target SOC section of the SOC-resistance profile.

As another example, the control unit 120 may be configured to set the maximum allowable SOC for the charging C-RATE corresponding to the SOC-resistance profile based on the at least one maximum point, if a resistance greater than the resistance corresponding to the upper limit SOC of the target SOC section exists among the plurality of resistances corresponding to the target SOC section and at least one maximum point exists in the target SOC section of the SOC-resistance profile.

As still another example, the control unit 120 may be configured to set the maximum allowable SOC for the charging C-RATE corresponding to the SOC-resistance profile based on the at least one inflection point, if a resistance greater than the resistance corresponding to the upper limit SOC of the target SOC section exists among the plurality of resistances corresponding to the target SOC section, there is no maximum point in the target SOC section, and at least one inflection point exists in the target SOC section.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference symbols)

1: vehicle
10: battery pack
11: battery
12: measuring unit
100: apparatus for diagnosing a battery
110: profile obtaining unit
120: control unit
130: storage unit

## Claims

1. An apparatus for diagnosing a battery, comprising:
a profile obtaining unit configured to obtain a charging profile representing a voltage change of a battery in a charging process according to a charging protocol in which a corresponding relationship between a charging C-RATE and a maximum allowable SOC is preset; and
a control unit configured to calculate a voltage change amount of the battery at a charging start point of the charging profile, calculate a target resistance of the battery based on the calculated voltage change amount, and diagnose a state of the battery by comparing the target resistance with a first resistance profile in which a target resistance of the battery calculated in a previous charging cycle is stored.

2. The apparatus for diagnosing a battery according to claim 1,
wherein the control unit is configured to change the charging protocol when the state of the battery is diagnosed as an abnormal state.

3. The apparatus for diagnosing a battery according to claim 1,
wherein the control unit is configured to obtain a SOC-resistance profile representing a corresponding relationship between a SOC (State of Charge) of the battery, which is charged while repeating a charging period and a resting period with each charging C-RATE included in the charging protocol, and a resistance of the resting period, and change a maximum allowable SOC corresponding to each charging C-RATE based on the obtained SOC-resistance profile.

4. The apparatus for diagnosing a battery according to claim 3,
wherein the control unit is configured to set the maximum allowable SOC for the charging C-RATE corresponding to the SOC-resistance profile to an upper limit SOC, when a resistance corresponding to the upper limit SOC of a target SOC section is largest among a plurality of resistances corresponding to the target SOC section of the SOC-resistance profile.

5. The apparatus for diagnosing a battery according to claim 3,
wherein the control unit is configured to set the maximum allowable SOC for the charging C-RATE corresponding to the SOC-resistance profile based on at least one maximum point, when a resistance greater than the resistance corresponding to an upper limit SOC of a target SOC section exists among a plurality of resistances corresponding to the target SOC section of the SOC-resistance profile and the at least one maximum point exists in the target SOC section of the SOC-resistance profile.

6. The apparatus for diagnosing a battery according to claim 3,
wherein the control unit is configured to set the maximum allowable SOC for the charging C-RATE corresponding to the SOC-resistance profile based on at least one inflection point, when a resistance greater than the resistance corresponding to an upper limit SOC of a target SOC section exists among a plurality of resistances corresponding to the target SOC section of the SOC-resistance profile, there is no maximum point in the target SOC section, and the at least one inflection point exists in the target SOC section.

7. The apparatus for diagnosing a battery according to claim 1,
wherein the control unit is configured to determine a first resistance section based on the first resistance profile and diagnose the state of the battery by comparing the first resistance section with the target resistance.

8. The apparatus for diagnosing a battery according to claim 7,
wherein the control unit is configured to determine a first resistance line for a plurality of resistances included in the first resistance profile, and determine the first resistance section by adding a preset resistance threshold value to the determined first resistance line.

9. The apparatus for diagnosing a battery according to claim 7,
wherein the control unit is configured to:
diagnose the state of the battery as a normal state when the target resistance belongs to the first resistance section, and
diagnose the state of the battery as an abnormal state when the target resistance does not belong to the first resistance section.

10. The apparatus for diagnosing a battery according to claim 9,
wherein the control unit is configured to calculate a sub-voltage change amount between a voltage of the battery immediately after the charging starts and a voltage at time when the charging has been in progress for a preset time in the charging profile, calculate a sub-resistance of the battery based on the calculated sub-voltage change amount, and diagnose the state of the battery based on the target resistance and the sub-resistance.

11. The apparatus for diagnosing a battery according to claim 10,
wherein the control unit is configured to determine a second resistance section based on a second resistance profile in which a sub-resistance of the battery calculated from the previous charging cycle is stored, and diagnose the state of the battery based on the result of comparing the first resistance section with the target resistance and the result of comparing the second resistance section with the sub-resistance.

12. The apparatus for diagnosing a battery according to claim 11,
wherein the control unit is configured to determine a second resistance line for a plurality of resistances included in the second resistance profile, and determine the second resistance section by adding a preset resistance threshold value to the determined second resistance line.

13. The apparatus for diagnosing a battery according to claim 11,
wherein the control unit is configured to:
diagnose the state of the battery as a normal state when the target resistance belongs to the first resistance section or the sub-resistance belongs to the second resistance section, and
diagnose the state of the battery as an abnormal state when the target resistance does not belong to the first resistance section and the sub-resistance does not belong to the second resistance section.

14. The apparatus for diagnosing a battery according to claim 1,
wherein the control unit is configured to calculate the voltage change amount by calculating a difference between an initial voltage of the battery just before the charging starts and a voltage of the battery immediately after the charging starts.

15. The apparatus for diagnosing a battery according to claim 14,
wherein the control unit is configured to calculate an initial resistance based on the voltage change amount and a charging current of the charging process, compare an initial SOC of the battery just before the charging begins with a preset target SOC, and calculate the target resistance based on the initial resistance according to the comparison result.

16. The apparatus for diagnosing a battery according to claim 15,
wherein the control unit is configured to:
determine the initial resistance as the target resistance, when the initial SOC is equal to the target SOC, and
calculate the target resistance from the initial resistance based on a resistance table preset to represent a resistance ratio for each SOC, when the initial SOC is different from the target SOC.

17. The apparatus for diagnosing a battery according to claim 16,
wherein the control unit is configured to calculate a total resistance for the battery by dividing the initial resistance by a resistance ratio corresponding to the initial SOC in the resistance table, and calculate the target resistance for the battery by multiplying the total resistance by a resistance ratio corresponding to the target SOC in the resistance table.

18. A battery pack, comprising the apparatus for diagnosing a battery according to any one of claims 1 to 17.

19. A method for diagnosing a battery, comprising:
a profile obtaining step of obtaining a charging profile representing a voltage change of a battery in a charging process according to a charging protocol in which a corresponding relationship between a charging C-RATE and a maximum allowable SOC is preset;
a voltage change amount calculating step of calculating a voltage change amount of the battery at a charging start point of the charging profile;
a target resistance calculating step of calculating a target resistance of the battery based on the calculated voltage change amount; and
a diagnosing step of diagnose a state of the battery by comparing the target resistance with a first resistance profile in which a target resistance of the battery calculated in a previous charging cycle is stored.

20. The method for diagnosing a battery according to claim 19, further comprising:
a charging protocol changing step of changing the charging protocol when the state of the battery is diagnosed as an abnormal state in the diagnosing step.
